# EUROPEAN PATENT APPLICATION

(11) **EP 4 750 244 A1**
(43) Date of publication of application: **27.05.2026**
(21) Application number: 25211287.5
(22) Date of filing: 27.10.2025
(51) Int. Cl.: H10B 43/27, H10B 51/20, H10B 61/00, H10B 63/00

(54) **SEMICONDUCTOR DEVICE AND METHOD OF MANUFACTURING THE SEMICONDUCTOR DEVICE**

(30) Priority: 26.11.2024 KR 20240170566
(71) Applicant: SK hynix Inc., Bubal-eub Icheon-si Gyeonggi-do 17336 (KR)
(72) Inventor: BAE, Jeong Hoon, 17336 Icheon-si, Gyeonggi-do (KR); YEON, Jeong Ho, 17336 Icheon-si, Gyeonggi-do (KR); PARK, Nam Kyun, 17336 Icheon-si, Gyeonggi-do (KR); PARK, Tae Hyung, 17336 Icheon-si, Gyeonggi-do (KR); YUN, Dong Yeol, 17336 Icheon-si, Gyeonggi-do (KR)
(74) Representative: Isarpatent

(57) **Abstract**

A semiconductor device may include: channel pillars (12) arranged in a first direction (I) and a second direction (II) intersecting the first direction and having a first interval (W1) in the first direction and a second interval (W2) in the second direction, the first interval being smaller than the second interval; a select line (13) surrounding the channel pillars arranged in the first direction and extending in the first direction; word lines (WL) stacked above the select line; and local bit lines (17) penetrating through the word lines and connected to the channel pillars.

## Description

### BACKGROUND

### 1. Technical Field

Embodiments of the present disclosure relate to an electronic device, and more particularly, to a semiconductor device and a manufacturing method of the semiconductor device.

### 2. Related Art

The degree of integration of a semiconductor device is primarily determined by an area occupied by a unit memory cell. Recently, as the integration of memory cells formed in a single layer on a substrate approaches its physical limits, a three-dimensional semiconductor device that stacks memory cells vertically on a substrate has been proposed. Furthermore, in order to improve the operational reliability of such a semiconductor device, various structures and manufacturing methods have been developed.

### SUMMARY

In an embodiment, a semiconductor device may include: channel pillars arranged along a first direction and a second direction intersecting the first direction, wherein the channel pillars are spaced apart by a first interval in the first direction and a second interval in the second direction, the first interval being smaller than the second interval; a select line surrounding multiple channel pillars arranged in the first direction and extending in the first direction; word lines stacked above the select line in a third direction perpendicular to the first and the second directions; and local bit lines extending through the word lines in the third direction and electrically connected to the channel pillars.

In an embodiment, a semiconductor device may include: local lines arranged in a first direction and a second direction that intersects the first direction and extending in a third direction perpendicular to the first and the second directions; global lines extending in the second direction; and select transistors connected between the local lines and the global lines, each select transistors including a corresponding one of channel pillars, the channel pillars being spaced apart by a first interval in the first direction and a second interval in the second direction, the first interval being different than the second interval.

In an embodiment, a manufacturing method of a semiconductor device may include: forming channel pillars arranged in a first direction and a second direction that intersects the first direction; forming a select line surrounding multiple channel pillars and extending in the first direction; forming insulating pillars extending through the select line in a third direction perpendicular to the first and the second directions; and forming a contact plug electrically connected to the select line between two adjacent insulating pillars.

In an embodiment, a method of manufacturing a semiconductor device may include: forming global bit lines; forming channel pillars over the global bit lines in a third direction, the channel pillars being arranged in a first direction and a second direction intersecting the first direction and spaced apart by an interval in the first direction smaller than an interval in the second direction, the third direction being perpendicular to both the first and second directions; forming select lines, each configured to surround multiple channel pillars in the first direction and extending in the first direction; forming local bit lines on the select lines in the third direction, the local bit lines being connected to the channel pillars, respectively, and extending in the third direction; and forming word lines surrounding the local bit lines and stacked in the third direction.

In an embodiment, a semiconductor device includes first and second select lines extending in a first direction, the first and second select lines being offset from each other in a second direction that is different from the first direction; first and second sets of channel pillars, the first set of channel pillars being associated with the first select line and the second set of channel pillars being associated with the second select line; word lines provided above the first and second select lines in a third direction that is different from the first direction and the second direction; and local bit lines extending through the word lines in the third direction and electrically coupled to the channel pillars.

The channel pillars in the first set are separated from adjacent channel pillars in the same set by a first interval in the first direction and separated from adjacent channel pillars in the second set by a second interval in the second direction, the first interval being smaller than the second interval.

The first select line surrounds the channel pillars in the first set, and the second select line surrounds the channel pillars in the second set. Each of the first direction, the second direction, and the third direction is substantially orthogonal to the other two directions.

### BRIEF DESCRIPTION OF THE DRAWINGS

FIGS. 1A to 1D illustrate the structure of a semiconductor device in accordance with an embodiment.
FIGS. 2A to 2D illustrate the structure of a semiconductor device in accordance with an embodiment.
FIGS. 3A, 4A, 5A, 6A, 7A, 8A, 9A, and 10A, FIGS. 3B, 4B, 5B, 6B, 7B, 8B, 9B, and 10B, and FIGS. 3C, 4C, 5C, 6C, and 7C describe a manufacturing method of a semiconductor device in accordance with an embodiment.
FIGS. 11A and 11B illustrate the structure of a semiconductor device in accordance with an embodiment.
FIG. 12 is a circuit diagram illustrating a cell array of a semiconductor device in accordance with an embodiment.
FIG. 13 is a flowchart for describing a manufacturing method of a semiconductor device in accordance with an embodiment.
FIGS. 14A to 14F describe a manufacturing method of a semiconductor device in accordance with an embodiment.
FIGS. 15A, 16A, and 17A and FIGS. 15B, 16B, and 17B describe a manufacturing method of a semiconductor device in accordance with an embodiment.
FIG. 18 is a cross-sectional view illustrating the structure of a semiconductor device in accordance with an embodiment.
FIG. 19 is a configuration diagram of a semiconductor device in accordance with an embodiment.
FIG. 20 is a configuration diagram of a semiconductor device in accordance with an embodiment.

### DETAILED DESCRIPTION

Various embodiments are directed to a semiconductor device having a stable structure and improved characteristics and a manufacturing method of the semiconductor device.

By stacking memory cells in three dimensions, it is possible to improve the degree of integration of a semiconductor device. It is also possible to provide a semiconductor device having a stable structure and improved reliability.

Hereafter, embodiments in accordance with the technical spirit of the present disclosure will be described with reference to the accompanying drawings.

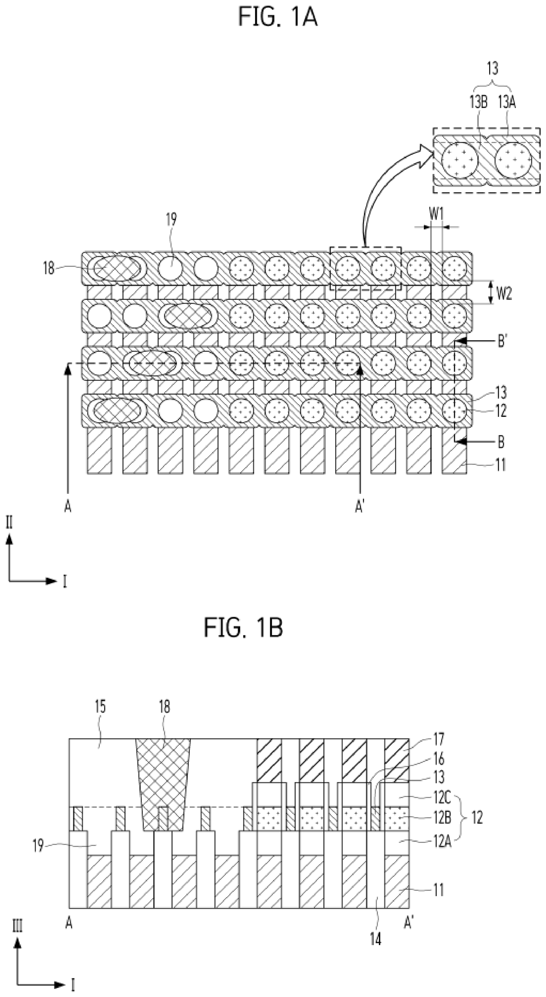

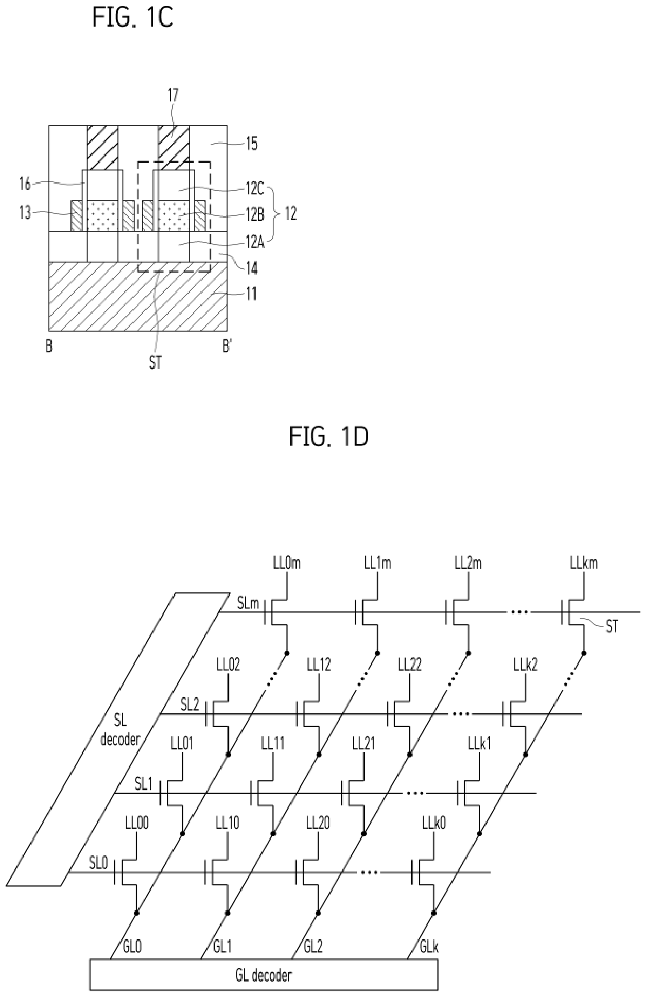

FIGS. 1A to 1D illustrate the structure of a semiconductor device in accordance with an embodiment. FIG. 1A is a plan view, FIG. 1B is a cross-sectional view taken along line A-A' of FIG. 1A, FIG. 1C is a cross-sectional view taken along line B-B' of FIG. 1A, and FIG. 1D is a circuit diagram.

Referring to FIGS. 1A to 1C, the semiconductor device may include channel pillars 12, a select line 13, and a local line 17. The semiconductor device may further include one or more of a global line 11, a gap-fill insulating layer 14, an interlayer insulating layer 15, a gate insulating layer 16, a contact plug 18, and insulating pillars 19. Here, the global line 11 may be a global bit line, and the local line 17 may be a local bit line.

In a plan view, the channel pillars 12 may be arranged in (e.g., a matrix form along) a first direction I and a second direction II, where the second direction II intersects the first direction I. The channel pillars 12 have a first interval W1 in the first direction I and a second interval W2 in the second direction II. The first interval W1 and the second interval W2 may be different from each other. In an implementation, the first interval W1 may be smaller than the second interval W2.

Each channel pillar 12 may include a first semiconductor layer 12A, a second semiconductor layer 12B, and a third semiconductor layer 12C. The first semiconductor layer 12A, the second semiconductor layer 12B, and the third semiconductor layer 12C may be stacked in a third direction III. The third direction III may be perpendicular to the first direction I and the second direction II. In an embodiment, the channel pillar 12 extends orthogonal to the first and second directions I and II and has a dimension in the third direction III that is greater than its dimension in the first direction I or the second direction II. The second semiconductor layer 12B may be located between the first semiconductor layer 12A and the third semiconductor layer 12C.

The first semiconductor layer 12A and the third semiconductor layer 12C may function as junctions, and the second semiconductor layer 12B may serve as a channel region. The first semiconductor layer 12A, the second semiconductor layer 12B, and the third semiconductor layer 12C may each include N-type impurities, P-type impurities, or be formed as intrinsic semiconductors. For example, the first semiconductor layer 12A may include N-type impurities, the second semiconductor layer 12B may include P-type impurities, and the third semiconductor layer 12C may include N-type impurities. Alternatively, the first semiconductor layer 12A may include P-type impurities, the second semiconductor layer 12B may include N-type impurities, and the third semiconductor layer 12C may include P-type impurities. In another configuration, the first semiconductor layer 12A may include N-type impurities, the second semiconductor layer 12B may be formed as an intrinsic semiconductor, and the third semiconductor layer 12C may include N-type impurities. Additionally, the first semiconductor layer 12A may include P-type impurities, the second semiconductor layer 12B may be formed as an intrinsic semiconductor, and the third semiconductor layer 12C may include P-type impurities.

The select line 13 extends in the first direction I and is associated with a group of channel pillars 12 arranged in the first direction I. In an embodiment, each of the select lines 13 is associated with a group or set of channel pillars, with the select line 13 surrounding or substantially surrounding the corresponding group of channel pillars. The multiple channel pillars 12 arranged in the first direction I may share the select line 13. For example, the select line 13 may surround the second semiconductor layer 12B of the channel pillar 12, while not surrounding the first semiconductor layer 12A and the third semiconductor layer 12C.

The select line 13 may extend in the first direction I. The select line 13 may include two parallel first portions 13A extending along the first direction I and second portions 13B, each connecting the two parallel first portions 13A. The second portions 13B may be located between the multiple channel pillars 12, between insulating pillars 19, and between a channel pillar 12 and an insulating pillar 19, along the first direction I.

The gate insulating layers 16 may surround sidewalls of the channel pillars 12, and may be interposed between the channel pillars 12 and the select line 13.

The global lines 11 may extend in the second direction II. The channel pillars 12 may be located on the global lines 11 in the third direction III. The global line 11 may be connected to a plurality of channel pillars 12 arranged in the second direction II. The first semiconductor layer 12A and the global line 11 may be connected to each other.

The local lines 17 may be arranged in a matrix form along the first direction I and the second direction II, and may be located to correspond to the channel pillars 12, respectively. The local lines 17 may each have a pillar shape. The local lines 17 may extend in the third direction III, for example, in a vertical direction. The local lines 17 may be located on the channel pillars 12 in the third direction III. The third semiconductor layer 12C and the local line 17 may be connected to each other. For example, the channel pillar 12 may be connected between the global bit line and the local bit line.

Select transistors ST may be located in regions where the global lines 11 intersects the select lines 13. Each select transistor ST may include a channel pillar 12, and the channel pillar 12 may include a first semiconductor layer 12A, a second semiconductor layer 12B, and a third semiconductor layer 12C. Here, the first semiconductor layer 12A may be a first junction, the third semiconductor layer 12C may be a second junction, and the second semiconductor layer 12B may be a channel region. The select line 13 may surround the channel region.

The gap-fill insulating layers 14 may be located between the global lines 11 in the first direction I. The gap-fill insulating layers 14 may also be located between the first semiconductor layers 12A along the first direction I and the second direction II. The interlayer insulating layer 15 may be located to cover the select line 13. The local lines 17 may penetrate through the interlayer insulating layer 15 and be connected to the channel pillars 12.

The insulating pillars 19 may penetrate through the select lines 13, and may be located on the global lines 11. The insulating pillars 19 may be arranged in a matrix form along the first direction I and the second direction II. The insulating pillars 19 may be formed by filling regions vacated by the removal of the channel pillars 12 with an insulating material. The insulating pillars 19 may be integrally connected to the interlayer insulating layer 15.

The contact plug 18 may penetrate through the interlayer insulating layer 15, and may be electrically connected to the select line 13. The contact plug 18 may be connected to the second portion 13B of the select line 13 between the insulating pillars 19 adjacent to each other in the first direction I. The contact plug 18 may surround an upper surface and sidewalls of the second portion 13B. A select signal may be applied to the select line 13 through the contact plug 18, enabling the select transistor ST to be turned on or off in response to the select signal.

Referring to FIG. 1D, the semiconductor device may include select lines SL0 to SLm, global lines GL0 to GLk, local lines LL00 to LLkm, select transistors ST, a global line decoder GL decoder, and a select line decoder SL decoder. The select transistors ST may be connected between the global lines GL0 to GLk and the local lines LL00 to LLkm. Here, the global lines GL0 to GLk may be global bit lines, and the local lines LL00 to LL33 may be local bit lines. The global line decoder GL decoder may be a global bit line decoder. k and m may be integers of 0 or more.

The global lines GL0 to GLk may be connected to the global line decoder GL decoder. The global line decoder GL decoder may include switches respectively connected to the global lines GL0 to GLk. By turning on or off the switches based on addresses, it is possible to selectively activate the global lines GL0 to GLk.

The select lines SL0 to SLm may be connected to gate electrodes of the select transistors ST, and may be connected to the select line decoder SL decoder. The select line decoder SL decoder may include switches respectively connected to the select lines SL0 to SLm. By turning on or off the switches based on addresses, it is possible to selectively activate the select lines SL0 to SLm.

According to the configuration described above, the connection between the global lines GL0 to GLk and the local lines LL00 to LLkm may be controlled by the select transistors ST. The local lines LL00 to LLkm, for example, the local bit lines, may be selected using the select line decoder SL decoder and the global line decoder GL decoder.

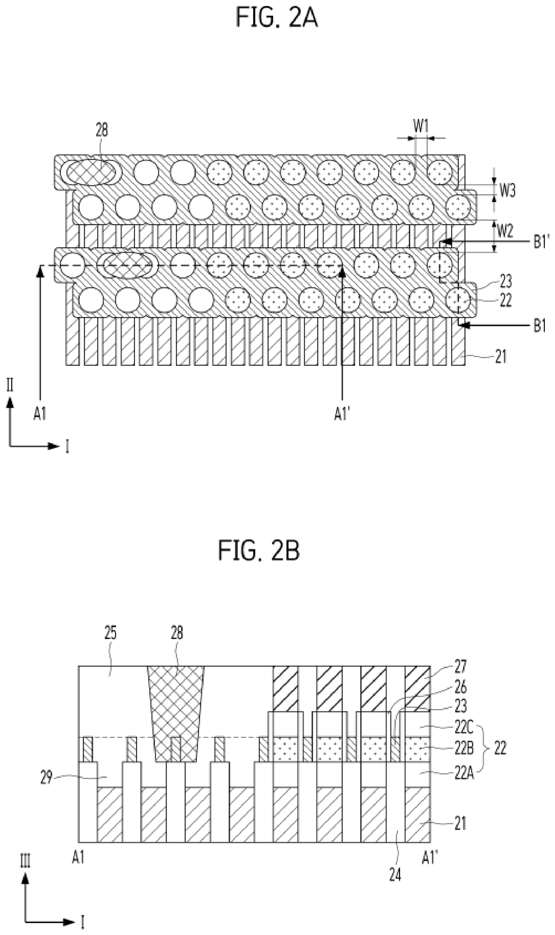

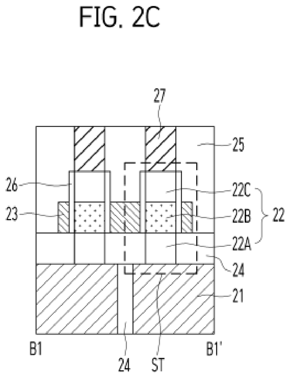

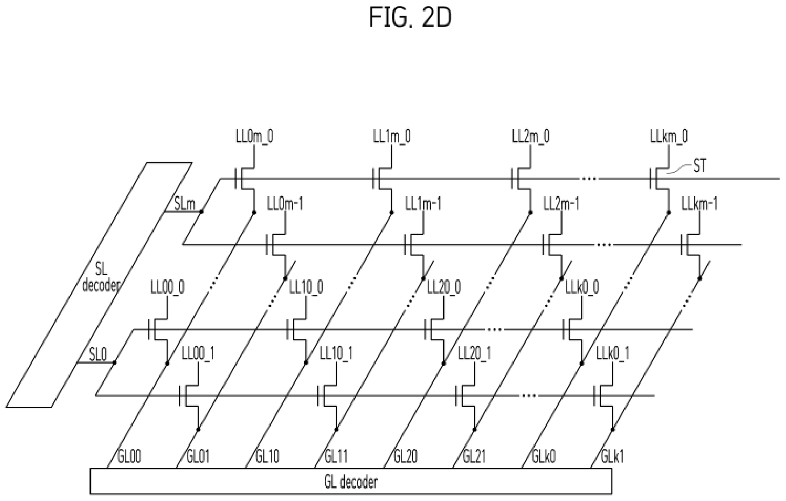

FIGS. 2A to 2D illustrate a semiconductor device in accordance with an embodiment. FIG. 2A is a plan view, FIG. 2B is a cross-sectional view taken along line A1-A1' of FIG. 2A, FIG. 2C is a cross-sectional view taken along line B1-B1' of FIG. 2A, and FIG. 2D is a circuit diagram.

Referring to FIGS. 2A to 2C, the semiconductor device may include channel pillars 22, a select line 23, and a local line 27. The semiconductor device may further include one or more of a global line 21, a gap-fill insulating layer 24, an interlayer insulating layer 25, a gate insulating layer 26, a contact plug 28, and insulating pillars 29. Here, the global line 21 may be a global bit line, and the local line 27 may be a local bit line.

The channel pillars 22 may be arranged in a zigzag pattern along the first direction I and the second direction II intersecting the first direction I. The channel pillars 22 adjacent to each other in the second direction II may be arranged with their centers staggered, forming the zigzag pattern. Each channel pillar 22 may include a first semiconductor layer 22A, a second semiconductor layer 22B, and a third semiconductor layer 22C.

The channel pillars 22 have a first interval W1 in the first direction I and a second interval W2 or a third interval W3 in the second direction II. The first interval W1 and the second interval W2 may be different from each other, and the second interval W2 and the third interval W3 may be different from each other. The first interval W1 may be smaller than the second interval W2, and the third interval W3 may be smaller than the second interval W2.

The select line 23 may surround the channel pillars 22, and may extend in the first direction I. For example, the channel pillars 22 arranged in the first direction I may constitute one row, and the select line 23 may surround at least two rows. The channel pillars 22 surrounded by the same select line 23 may be spaced apart from each other by the first interval W1 in the first direction I and the third interval W3 in the second direction II. The channel pillars 22 surrounded by different select lines 23 may be spaced apart from each other by the second interval W2 in the second direction II.

Referring to FIG. 2D, the semiconductor device may include select lines SL0 to SLm, global lines GL00 to GLk1, local lines LL00_0 to LLkm_1, select transistors ST, a global line decoder GL decoder, and a select line decoder SL decoder. The select transistors ST may be connected between the global lines GL00 to GLk1 and the local lines LL00_0 to LLkm_1.

The global lines GL00 to GLk1 may be connected to the global line decoder GL decoder. The select lines SL0 to SLm may be connected to gate electrodes of the select transistors ST, and may be connected to the select line decoder SL decoder.

According to the configuration described above, the connection between the global lines GL00 to GLk1 and the local lines LL00_0 to LLkm_1 may be controlled by the select transistors ST. The local lines LL00_0 to LLkm_1, for example, the local bit lines, may be selected using the select line decoder SL decoder and the global line decoder GL decoder.

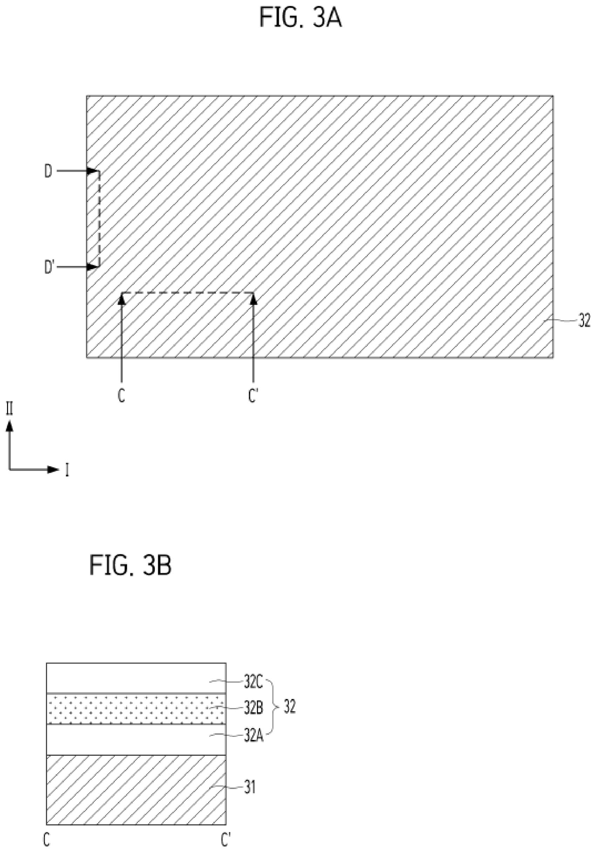

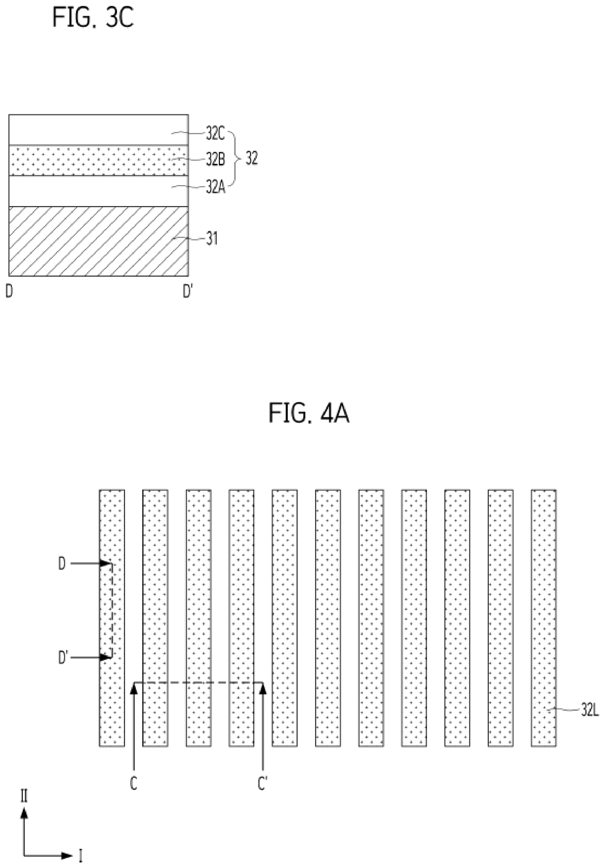

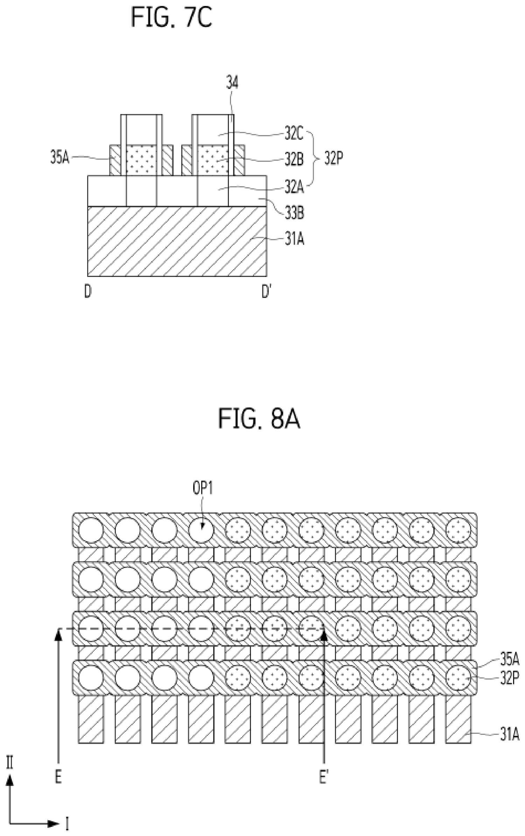

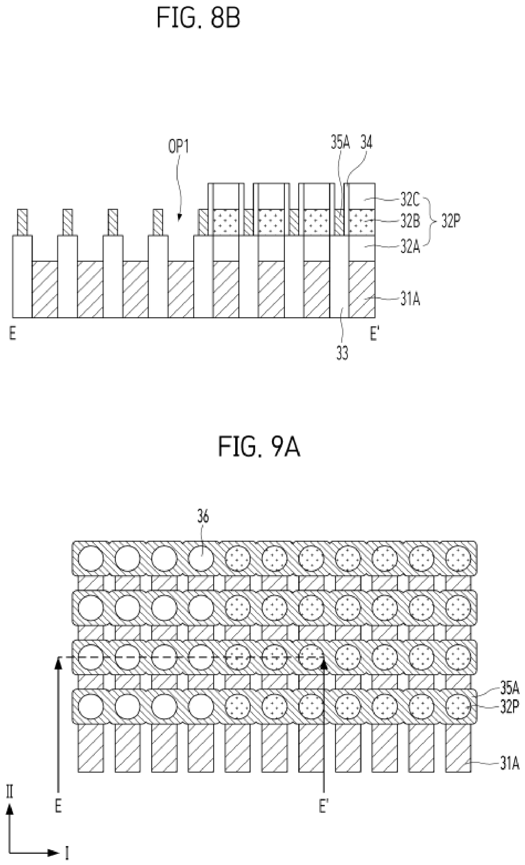

FIGS. 3A, 4A, 5A, 6A, 7A, 8A, 9A, and 10A, FIGS. 3B, 4B, 5B, 6B, 7B, 8B, 9B, and 10B, and FIGS. 3C, 4C, 5C, 6C, and 7C illustrate a manufacturing method of a semiconductor device in accordance with an embodiment. FIGS. 3A, 4A, 5A, 6A, 7A, 8A, 9A, and 10A are plan views, FIGS. 3B, 4B, 5B, 6B, and 7B are cross-sectional views taken along lines C-C' of FIGS. 3A, 4A, 5A, 6A, and 7A, respectively, FIGS. 3C, 4C, 5C, 6C, and 7C are cross-sectional views taken along lines D-D' of FIGS. 3A, 4A, 5A, 6A, and 7A, respectively, and FIGS. 8B, 9B, and 10B are cross-sectional views taken along lines E-E' of FIGS. 8A, 9A, and 10A, respectively.

Referring to FIGS. 3A to 3C, a semiconductor layer 32 is formed on a first conductive layer 31. The semiconductor layer 32 includes a first semiconductor layer 32A, a second semiconductor layer 32B, and a third semiconductor layer 32C that are sequentially stacked in the third direction III. For example, the first semiconductor layer 32A is an N-type semiconductor layer and formed on the first conductive layer 31, the second semiconductor layer 32B is a P-type semiconductor layer and formed on the first semiconductor layer 32A, and the third semiconductor layer 32C is an N-type semiconductor layer and formed on the second semiconductor layer 32B.

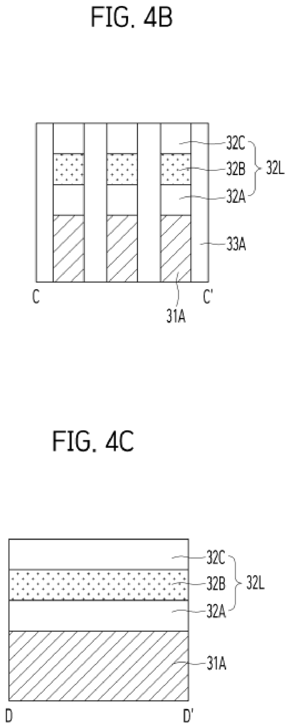

Referring to FIGS. 4A to 4C, semiconductor lines 32L extending in the second direction II are formed by etching or patterning the semiconductor layer 32. Subsequently, global lines 31A extending in the second direction II are formed by etching the first conductive layer 31. Here, the global lines 31A may be global bit lines.

Subsequently, first gap-fill insulating layers 33A may be formed between the semiconductor lines 32L and between the global lines 31A. The first gap-fill insulating layers 33A may extend in the second direction II.

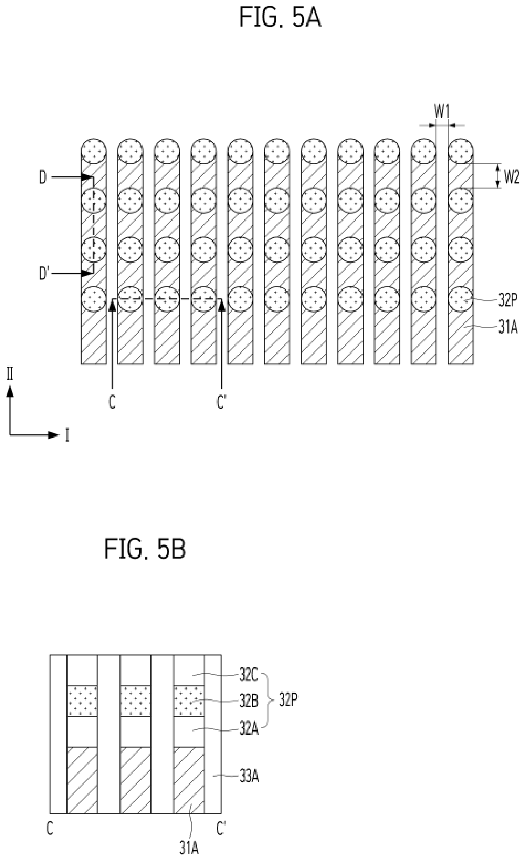

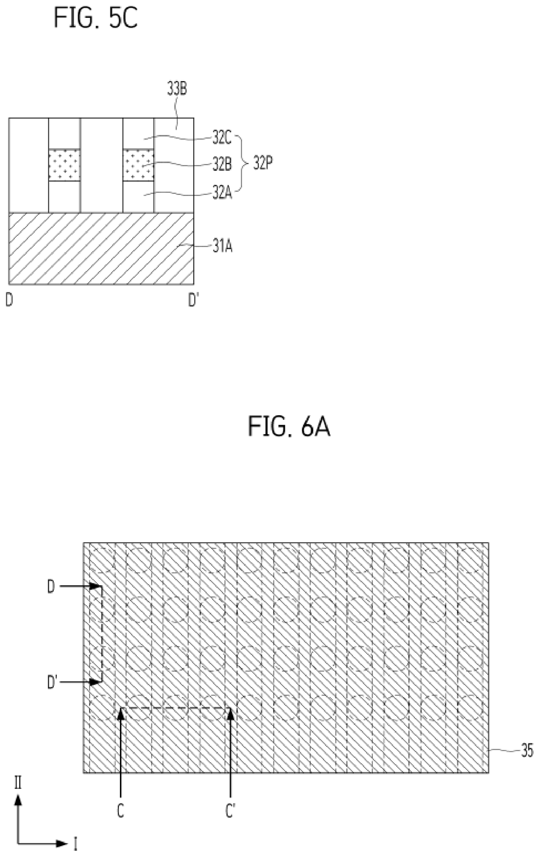

Referring to FIGS. 5A to 5C, channel pillars 32P are formed by etching the semiconductor lines 32L. The channel pillars 32P may be arranged in a matrix form along the first direction I and the second direction II. The channel pillars 32P may have a first interval W1 in the first direction I and a second interval W2 in the second direction II, and the first interval W1 may be smaller than the second interval W2. For example, trenches extending in the first direction I are formed by etching the semiconductor lines 32L and the first gap-fill insulating layers 33A. The channel pillars 32P adjacent to each other in the second direction II may be separated from each other by the trenches. Subsequently, second gap-fill insulating layers 33B may be formed in the trenches.

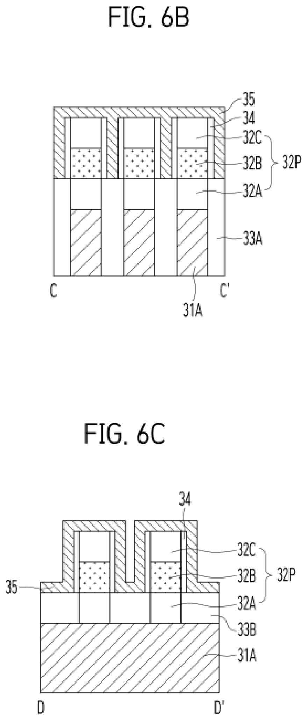

Referring to FIGS. 6A to 6C, sidewalls of the channel pillars 32P are exposed by etching the first gap-fill insulating layer 33A and the second gap-fill insulating layer 33B. For example, the first gap-fill insulating layer 33A and the second gap-fill insulating layer 33B are etched by an etch-back process. Through this, the second semiconductor layer 32B and the third semiconductor layer 32C of each channel pillar 32P may be exposed.

Subsequently, gate insulating layers 34 may be formed on the channel pillars 32P. The gate insulating layers 34 may be formed to surround the exposed sidewalls of the channel pillars 32P. For example, the sidewalls of the second semiconductor layer 32B and third semiconductor layer 32C of each channel pillar 32P are surrounded by the gate insulating layer 34. The gate insulating layers 34 may each include an oxide.

Subsequently, a second conductive layer 35 is formed on the gate insulating layers 34 and covers upper surfaces of the channel pillars 32P. Because the channel pillars 32P adjacent to each other in the first direction I have a relatively small interval, the second conductive layer 35 may fill a space between the channel pillars 32P adjacent to each other in the first direction I. On the other hand, because the channel pillars 32P adjacent to each other in the second direction II have a relatively great interval, the second conductive layer 35 may only partially fill a space between the channel pillars 32P adjacent to each other in the second direction II. The second conductive layer 35 may include a metal such as tungsten.

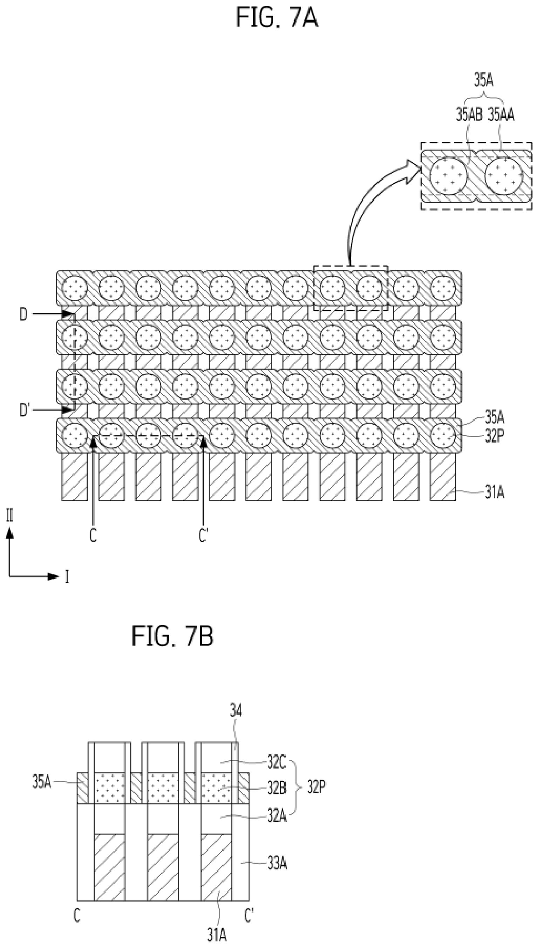

Referring to FIGS. 7A to 7C, select lines 35A extending in the first direction I are formed by etching the second conductive layer 35. For example, the second conductive layer 35 is etched using an etch-back process. As the second conductive layer 35 is etched back, the upper surfaces of the channel pillars 32P, the gate insulating layers 34, and upper surfaces of the second gap-fill insulating layers 33B may be exposed.

Subsequently, a treatment process may be performed on the channel pillars 32P. For example, a CO₂ laser annealing process may be performed. Through this, electron mobility of the channel pillars 32P may be increased, and channel characteristics may be improved.

Each select line 35A may fill the space between the channel pillars 32P adjacent to each other in the first direction I. Each select line 35A may extend in the first direction I while surrounding sidewalls of the channel pillars 32P arranged in the first direction I. The select lines 35A may each have a height sufficient to surround the second semiconductor layers 32B, while potentially not surrounding the third semiconductor layers 32C. Each select line 35A may include two parallel first portions 35AA extending in the first direction I and a second portion 35AB located between the channel pillars 32P, connecting the two parallel first portions 35AA.

Referring to FIGS. 8A and 8B, first openings OP1 are formed by removing some of the channel pillars 32P. The global lines 31A may be exposed through the first openings OP1. For example, a mask pattern exposing ends of the select lines 35A may be formed, and the channel pillars 32P exposed by the mask pattern may be removed. The exposed channel pillars 32P may be removed using a dip-out process. The dip-out process may be a wet etching process having a high etching selectivity with respect to the channel pillars 32P. During the dip-out process, the gate insulating layers 34 may be removed together with the channel pillars 32P.

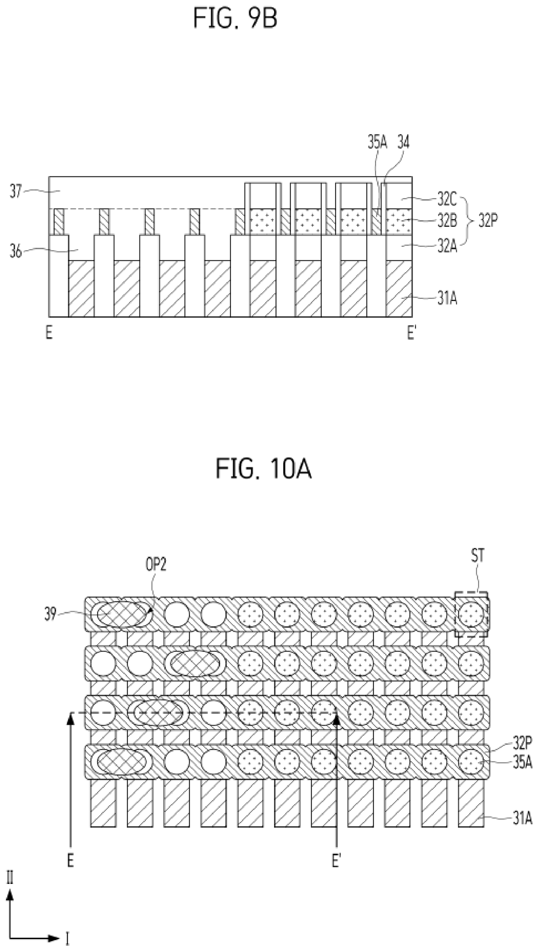

Referring to FIGS. 9A and 9B, insulating pillars 36 may be formed within the first openings OP1. The insulating pillars 36 may penetrate through the select lines 35A, and may be located above the global lines 31A. In other words, the select line 35A may fill spaces between the insulating pillars 36 arranged in the first direction I, and may extend in the first direction I while surrounding sidewalls of the insulating pillars 36.

An insulating layer 37 may be formed above the insulating pillars 36 and the channel pillars 32P. The insulating layer 37 may fill the spaces between the channel pillars 32P. The insulating pillars 36 and the insulating layer 37 may be simultaneously formed, and may constitute a single, integrally connected layer.

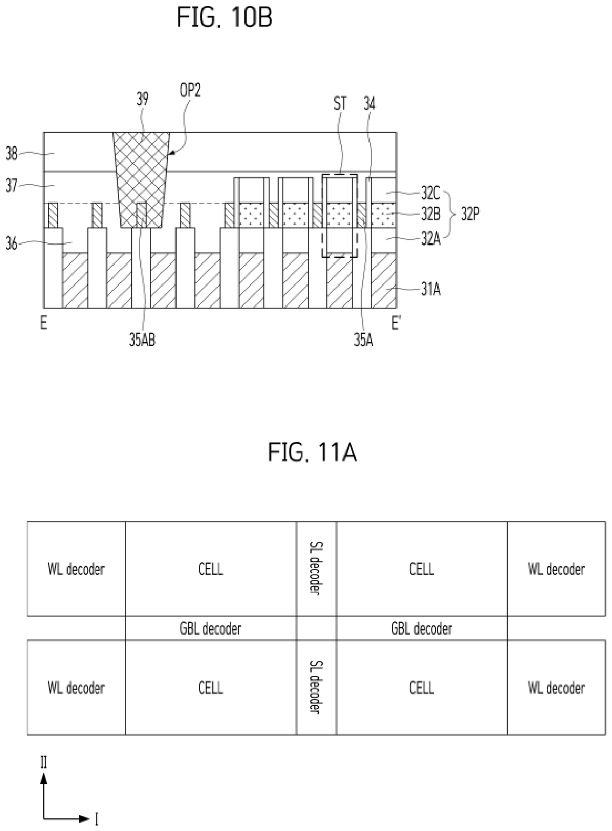

Referring to FIGS. 10A and 10B, an interlayer insulating layer 38 may be formed above a resultant structure of FIGS. 9A and 9B. The interlayer insulating layer 38 may be formed above the insulating layer 37. Subsequently, second openings OP2 respectively exposing the select lines 35A are formed. The second openings OP2 may penetrate through the interlayer insulating layer 38 and the insulating layer 37. In a process of forming each second opening OP2, a pair of insulating pillars 36 adjacent to each other in the first direction I may be partially etched, and the second portion 35AB located between the pair of insulating pillars 36 may be exposed.

Subsequently, contact plugs 39 may be formed in the second openings OP2. The contact plugs 39 may be electrically connected to the select lines 35A, respectively. Each contact plug 39 may be electrically connected to the select line 35A exposed between the insulating pillars 36. The contact plug 39 may be connected to the second portion 35AB of the select line 35A exposed between the pair of insulating pillars 36 adjacent to each other in the first direction I.

The insulating pillars 36 may be located between the contact plugs 39 and the global lines 31A in the third direction III, providing insulation between the contact plugs 39 and the global lines 31A. A plurality of contact plugs 39 may be arranged in a zigzag pattern or in a staggered configuration.

Meanwhile, although not illustrated in FIGS. 10A and 10B, local lines respectively connected to the channel pillars 32P may be formed. Each local line may have a pillar-like shape and may penetrate through the interlayer insulating layer 38 and the insulating layer 37. The local lines may be local bit lines.

According to the manufacturing method described above, select transistors ST arranged in the first direction I and the second direction II may be formed. The contact plugs 39 respectively connected to the select lines 35A may also be formed. Select signals may be applied to the select lines 35A through the contact plugs 39, enabling the select transistors ST to be turned on or off in response to the select signals.

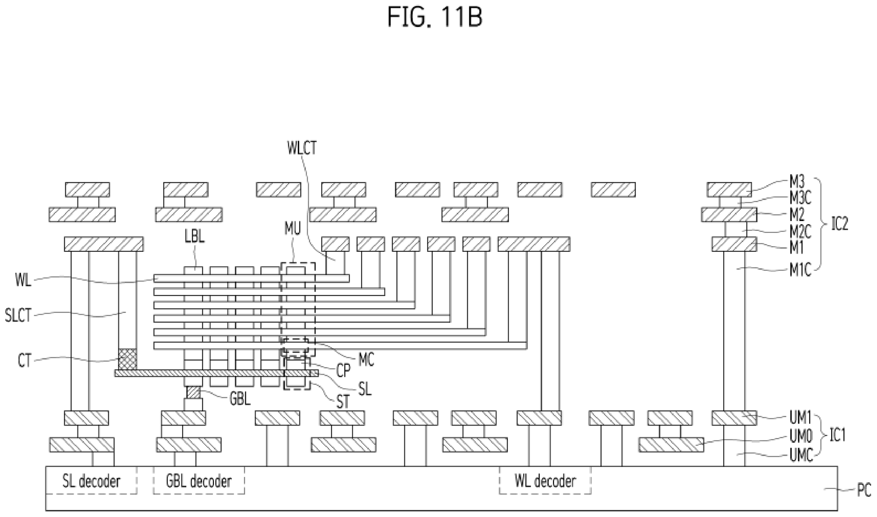

FIGS. 11A and 11B illustrate a semiconductor device in accordance with an embodiment. Hereinafter, the content overlapping with the previously described content may be omitted.

Referring to FIG. 11A, the semiconductor device may include a cell region CELL in which stacked memory cells are located. In addition, the semiconductor device may include peripheral circuits located around the cell region CELL. Here, the peripheral circuit may include a global bit line decoder GBL decoder, a select line decoder SL decoder, and a word line decoder WL decoder.

The cell regions CELL may be arranged in the first direction I and the second direction II. The select line decoder SL decoder may be located between two cell regions CELL adjacent to each other in the first direction I. The global bit line decoder GBL decoder may be located between two cell regions CELL adjacent to each other in the second direction II. The word line decoder WL decoder and the select line decoder SL decoder may be adjacent to each other in the first direction I, and the cell region CELL may be located between the word line decoder WL decoder and the select line decoder SL decoder in the first direction I.

The cell regions CELL and the peripheral circuit may be located at the same level or at different levels in the third direction III. For example, the peripheral circuit may be located below the cell regions CELL. The cell regions CELL and the peripheral circuit, located at different levels, may be electrically connected through an interconnection structure. The interconnection structure may include at least one via and at least one wiring line.

Referring to FIG. 11B, the semiconductor device may include a peripheral circuit PC, a global bit line GBL, a select line SL, a word line WL, a local bit line LBL, a contact plug CT, a select line contact plug SLCT, a word line contact plug WLCT, a first interconnection structure IC1, and a second interconnection structure IC2. For reference and ease of explanation, an insulating layer and an interlayer insulating layer have been omitted in FIG. 11B.

The peripheral circuit PC may be located below the global bit line GBL, the select line SL, and the word lines WL. The peripheral circuit PC may include a global bit line decoder GBL decoder, a select line decoder SL decoder, and a word line decoder WL decoder. The global bit line decoder GBL decoder may be located below the global bit line GBL, and may be connected to the global bit line GBL. The select line decoder SL decoder may be located below the global bit line GBL, and may be connected to the select line SL.

The global bit line GBL may be located above the peripheral circuit PC, the select line SL may be located above the global bit line GBL, and the word lines WL may be located above the select line SL. The word lines WL may surround the local bit line LBL, and may be stacked in the third direction III. The global bit line GBL and the select line SL may extend in mutually intersecting directions.

The contact plug CT may be electrically connected to the select line SL, and the select line contact plug SLCT may be electrically connected to the contact plug CT. The select line contact plug SLCT may be electrically connected to the second interconnection structure IC2.

Channel patterns CP may penetrate through the select line SL. Lower ends of the channel patterns CP may be connected to global bit lines GBL, and upper ends of the channel patterns CP may be connected to the local bit lines LBL. Select transistors ST may be located in regions where the channel patterns CP intersect the select lines SL.

The first interconnection structure IC1 may be located above the peripheral circuit PC, and may be located below the select line SL. The first interconnection structure IC1 may be electrically connected to the peripheral circuit PC. The first interconnection structure IC1 may include wiring lines UM0 and UM1 and vias UMC. The second interconnection structure IC2 may be located at a different level from the first interconnection structure IC1 in the third direction III, and may be located above the word lines WL. The second interconnection structure IC2 may be electrically connected to the word line contact plug WLCT, the select line contact plug SLCT, the first interconnection structure IC1, and the like. The second interconnection structure IC2 may include wiring lines M1, M2, and M3 and vias M1C, M2C, and M3C.

The global bit line GBL may be connected to the global bit line decoder GBL decoder through the first interconnection structure IC1. The contact plug CT and the select line contact plug SLCT may be connected to the select line SL, and the select line SL may be connected to the select line decoder SL decoder through the first interconnection structure IC1 and the second interconnection structure IC2.

The word lines WL may be stacked above the select line SL, and the local bit line LBL may penetrate through the word lines WL and be connected to a channel pillar of the select transistor ST. Memory cells MC may be located in regions where the local bit line LBL intersects the word lines WL. The memory cells MC may be stacked along the local bit line LBL, and the memory cells MC stacked along the same local bit line LBL may constitute a memory unit MU.

Each memory cell MC may include a variable resistance layer capable of reversibly transitioning between different resistance states in response to a voltage or a current applied to the memory cell MC. For example, when the variable resistance layer has a low resistance state, data 1' may be stored, and when the variable resistance layer has a high resistance state, data '0' may be stored.

For example, the variable resistance layer may include a resistive material in which an electrical path is either formed or disrupted, enabling data storage. The variable resistance layer may include a transition metal oxide or a metal oxide, such as a perovskite-based material.

For example, the variable resistance layer may have a magnetic tunnel junction (MTJ) structure including a magnetization pinned layer, a tunnel barrier layer, and a magnetization free layer. Data may be stored based on changes in the magnetization direction of the magnetization free layer relative to the magnetization direction of the magnetization pinned layer. The magnetization pinned layer and the magnetization free layer may each include a magnetic material, while the tunnel barrier layer may include a metal oxide.

For example, the variable resistance layer may include a phase change material or a chalcogenide-based material, capable of changing its phase during a program operation. Through a set operation, the variable resistance layer may transition to a low resistance crystalline state. Conversely, through a reset operation, the variable resistance layer may transition to a high resistance amorphous state. Accordingly, data may be stored in the memory cell MC based on a difference in resistance corresponding to the phase of the variable resistance layer.

For example, the variable resistance layer may include a variable resistance material whose resistance changes without undergoing a phase change, or it may include a chalcogenide-based material. The variable resistance layer may retain its phase after the program operation. For example, the variable resistance layer may remain in an amorphous state without transitioning to a crystalline state after the program operation. A threshold voltage of the memory cell MC may vary based on a program voltage applied to the memory cell MC, allowing the memory cell MC to be programmed into at least two states. For example, the memory cell MC may be programmed to a set state or a reset state using program voltages having different polarities. Accordingly, data may be stored in the memory cell MC based on a difference in the threshold voltage of the memory cell MC.

The word line contact plugs WLCT may be connected to the word lines WL, respectively. For example, the word lines WL may be stacked in a staircase shape, and the word line contact plugs WLCT may be connected to ends of the word lines WL, respectively. The word lines WL may be connected to the word line decoder WL decoder through the word line contact plugs WLCT, the second interconnection structure IC2, and the first interconnection structure IC1.

For reference, the word lines WL may also be stacked flatly without the staircase shape, with the word line contact plugs WLCT extending through the word lines WL. In this configuration, the penetrated word lines WL and the word line contact plug WLCT may be insulated from each other. Additionally, the word lines WL and the word line contact plugs WLCT may be connected in a one-to-one manner.

According to the structure described above, placing the peripheral circuit PC below the cell region CELL can improve the degree of integration of the semiconductor device. Additionally, by locating the select transistors ST below the stacked word lines WL and connecting the select transistors ST between the global bit lines GBL and the local bit lines LBL, it is possible to select a desired local bit line LBL.

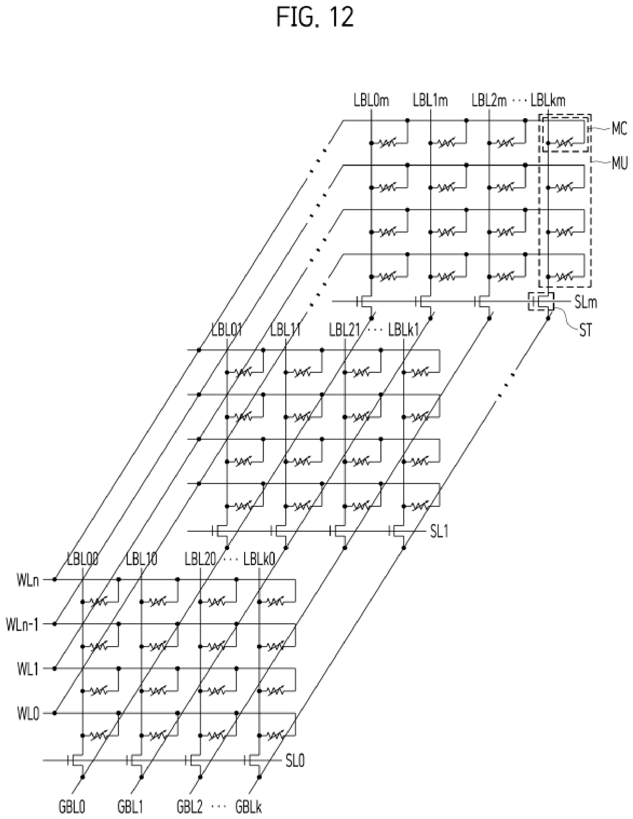

FIG. 12 is a circuit diagram illustrating a cell array of a semiconductor device in accordance with an embodiment. Hereinafter, the content overlapping with the previously described content may be omitted.

Referring to FIG. 12, the semiconductor device may include select lines SL0 to SLm, global bit lines GBLO to GBLk, local bit lines LBL00 to LBLkm, word lines WL0 to WLn, memory cells MC, select transistors ST, and memory units MU. Here, m, n, and k may be integers of 0 or more.

The memory cells MC may be connected between the local bit lines LBL00 to LBLkm and the word lines WL0 to WLn, and may be stacked in the third direction III. Here, the third direction III may be a direction perpendicular to a plane defined by the first direction I and the second direction II. The word lines WL0 to WLn may be connected to gate electrodes of the memory cells MC. Memory cells MC connected to the same local bit line may constitute one memory unit MU.

The select transistors ST may be connected to the memory units MU, respectively. The select lines SL1 to SLm may be connected to gate electrodes of the select transistors ST, and may extend in the first direction I. The global bit lines GBLO to GBLk may extend in the second direction II, and each of the select transistors ST may be connected between a corresponding one of the local bit lines LBL00 to LBLkm and a corresponding one of the global bit lines GBLO to GBLk.

With the configuration described above, a desired memory unit MU can be selected using the select transistors ST. This enables set and reset operations to be performed on individual memory units MU.

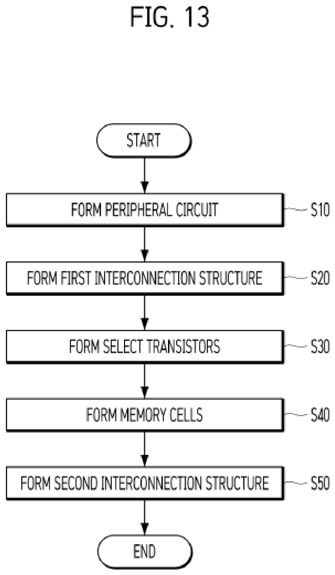

FIG. 13 is a flowchart for describing a manufacturing method of a semiconductor device in accordance with an embodiment. Hereinafter, the content overlapping with the previously described content may be omitted.

First, a peripheral circuit PC may be formed on a substrate (S10). The peripheral circuit PC may include a select line decoder SL decoder, a global bit line decoder GBL decoder, and a word line decoder WL decoder. Subsequently, a first interconnection structure IC1 electrically connected to the peripheral circuit PC may be formed (S20). The first interconnection structure IC1 may include a wiring line, a via, and the like.

Subsequently, select transistors ST may be formed (S30). Global bit lines GBL may be formed, and the select transistors ST may be formed above the global bit lines GBL.

Subsequently, memory cells MC may be formed (S40). Word lines WL stacked above the select transistors ST and local bit lines LBL penetrating through the word lines WL may be formed. The memory cells MC may be connected between the word lines WL and the local bit lines LBL. The select transistors ST may be connected between the local bit lines LBL and the global bit lines GBL.

Subsequently, a second interconnection structure IC2 may be formed (S50). The second interconnection structure IC2 may be electrically connected to the select line SL, the word line WL, the first interconnection structure IC1, and the like. The second interconnection structure IC2 may include a wiring line, a via, and the like.

In the present embodiment, a configuration where the peripheral circuit and a cell array are sequentially formed on the substrate has been described, but the present disclosure is not limited thereto. It is also possible to separately manufacture a peripheral circuit chip including the peripheral circuit and a cell chip including the cell array, and then bond the peripheral circuit chip and the cell chip together.

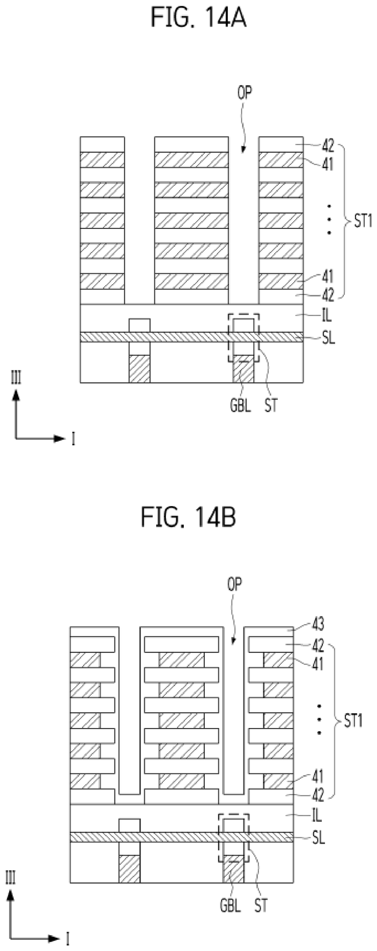

FIGS. 14A to 14F illustrate a manufacturing method of a semiconductor device in accordance with an embodiment, and are cross-sectional views of a cell region CELL. Hereinafter, the content overlapping with the previously described content may be omitted.

Referring to FIG. 14A, a stack ST1 is formed. The stack ST1 may be formed above select transistors ST. A global bit line GBL, a select line SL, the select transistor ST, and an interlayer insulating layer IL may have structures according to the embodiment described above with reference to FIGS. 1A to 1C, and may be formed by the manufacturing method according to the embodiment described above with reference to FIGS. 3A, 4A, 5A, 6A, 7A, 8A, 9A, and 10A, FIGS. 3B, 4B, 5B, 6B, 7B, 8B, 9B, and 10B, and FIGS. 3C, 4C, 5C, 6C, and 7C.

The stack ST1 may include first material layers 41 and second material layers 42 that are alternately stacked in the third direction III. The first material layers 41 may be used to form word lines, and the second material layers 42 may be used to insulate the stacked word lines from each other. The first material layers 41 may each include a material having a high etching selectivity with respect to the second material layers 42. For example, the first material layers 41 may each include a sacrificial material, such as nitride, and the second material layers 42 may each include an insulating material, such as oxide. The first material layers 41 may each include a conductive material such as polysilicon, tungsten, molybdenum, or the like.

Subsequently, openings OP are formed through the stack ST1. The openings OP may penetrate through the stack ST1, and may expose an upper surface of the interlayer insulating layer IL. The openings OP may be located to correspond to the select transistors ST and align with channel pillars of the select transistors ST. For example, in a plan view, the openings OP may be arranged in the first direction I and the second direction II, and an interval between the openings OP in the first direction I may be smaller than an interval between the openings OP in the second direction II.

Referring to FIG. 14B, recess regions are formed by etching the first material layers 41 exposed through the openings OP. The recess regions expand the openings OP in a horizontal direction at levels corresponding to the first material layers 41. Subsequently, a first electrode layer 43 may be formed along a surface of the stack ST1 exposed by the expanded openings OP. The first electrode layer 43 may be formed at a thickness sufficient to fill the recess regions.

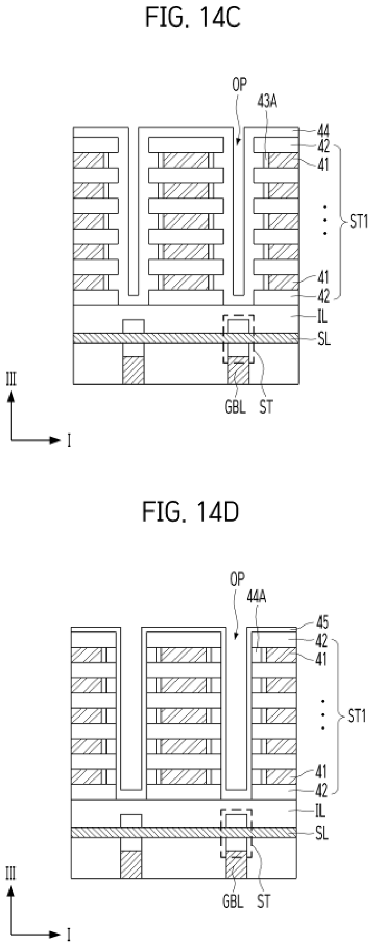

Referring to FIG. 14C, first electrodes 43A are formed by etching the first electrode layer 43. The first electrodes 43A may be located in the recess regions, respectively. Subsequently, a variable resistance material 44 is deposited along surfaces of the stack ST1 and the first electrodes 43A exposed through the openings OP. The variable resistance material 44 may be formed at a thickness sufficient to fill the recess regions.

Referring to FIG. 14D, variable resistance layers 44A are formed by etching the variable resistance material 44. The variable resistance layers 44A may be located in the recessed regions, respectively. Subsequently, a second electrode layer 45 is formed along surfaces of the stack ST1 and the variable resistance layers 44A exposed through the openings OP.

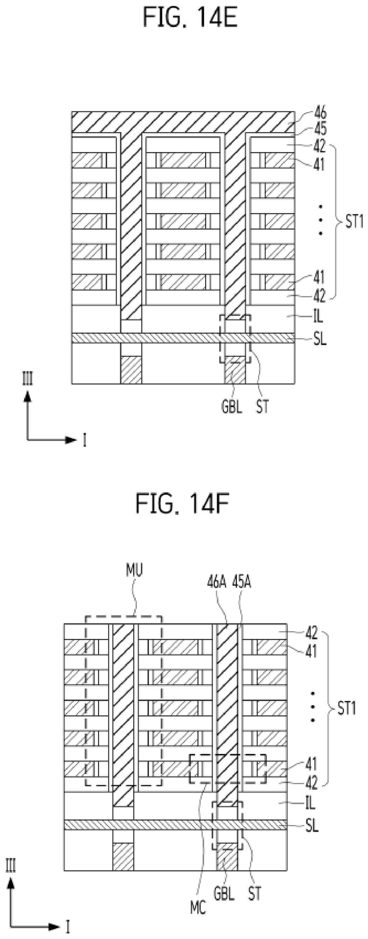

Referring to FIG. 14E, a portion of the second electrode layer 45 formed on the upper surface of the interlayer insulating layer IL may be etched. Subsequently, the openings OP may be expanded downward by etching the interlayer insulating layer IL, thereby exposing the channel pillars of the select transistors ST. Subsequently, a conductive layer 46 is formed on the second electrode layer 45. The conductive layer 46 may be formed along surfaces of the second electrode layer 45 and the interlayer insulating layer IL, filling the openings OP. The conductive layer 46 may include a metal, such as tungsten.

Referring to FIG. 14F, the conductive layer 46 and the second electrode layer 45 may be etched. A second electrode 45A and local bit lines 46A may be formed by planarizing the conductive layer 46 and the second electrode layer 45 until an upper surface of the stack ST1 is exposed. The planarization process may be performed by a chemical mechanical polish (CMP) method.

Each local bit line 46A may have a pillar shape, and the second electrode 45A may surround a sidewall of the local bit line 46A. The variable resistance layers 44A and the first electrodes 43A may surround the second electrode 45A. The variable resistance layers 44A and the first electrodes 43A may be located between the second material layers 42 stacked in the third direction III, and may each have a ring shape. The local bit lines 46A may extend through the stack ST1 in the third direction III, and may be connected to the channel pillars of the select transistors ST, respectively.

According to the manufacturing method described above, memory cells MC stacked along the local bit lines 46A may be formed. Each memory cell MC may include the first electrode 43A, the variable resistance layer 44A, and the second electrode 45A. The memory cells MC sharing the same local bit line 46A may constitute one memory unit MU.

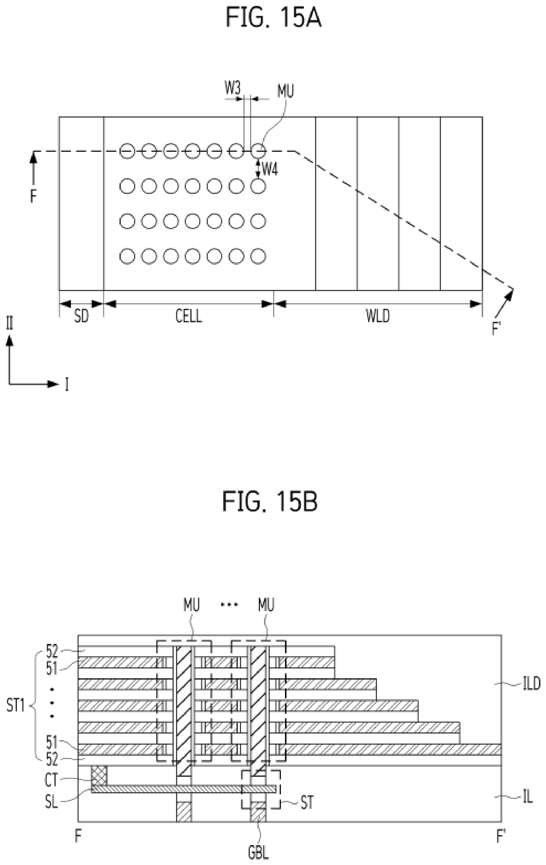

FIGS. 15A, 16A, and 17A and FIGS. 15B, 16B, and 17B illustrate a manufacturing method of a semiconductor device in accordance with an embodiment, and illustrate a select line decoder region, a cell region, and a word line decoder region. FIGS. 15A, 16A, and 17A illustrate layouts, and FIGS. 15B, 16B, and 17B are cross-sectional views taken along lines F-F' of FIGS. 15A, 16A, and 17A, respectively. Hereinafter, the content overlapping with the previously described content may be omitted.

Referring to FIGS. 15A and 15B, a global bit line GBL, a select line SL, a select transistor ST, an interlayer insulating layer IL, and a contact plug CT are formed. The global bit line GBL, the select line SL, the select transistor ST, the interlayer insulating layer IL, and the contact plug CT may have structures according to the embodiment described above with reference to FIGS. 1A to 1C, and may be formed by the manufacturing method according to the embodiment described above with reference to FIGS. 3A, 4A, 5A, 6A, 7A, 8A, 9A, and 10A, FIGS. 3B, 4B, 5B, 6B, 7B, 8B, 9B, and 10B, and FIGS. 3C, 4C, 5C, 6C, and 7C.

A stack ST1 and memory units MU are formed. In the stack ST1, first material layers 51 and second material layers 52 are alternately stacked in the third direction III. The stack ST1 may be formed in a select line decoder region SD, a cell region CELL, and a word line decoder region WLD. The memory units MU may be located to correspond to select transistors ST, and may have an interval W3 in the first direction I smaller than an interval W4 in the second direction II. The stack ST1 and the memory units MU may have structures according to the embodiment described above with reference to FIGS. 11A and 11B, and may be formed by the manufacturing method according to the embodiment described above with reference to FIGS. 14A to 14F.

Subsequently, the word line decoder region WLD of the stack ST1 may be patterned to have a staircase structure. Each of the first material layers 51 may be exposed through the staircase structure. Subsequently, an interlayer insulating layer ILD may be formed on the stack ST1.

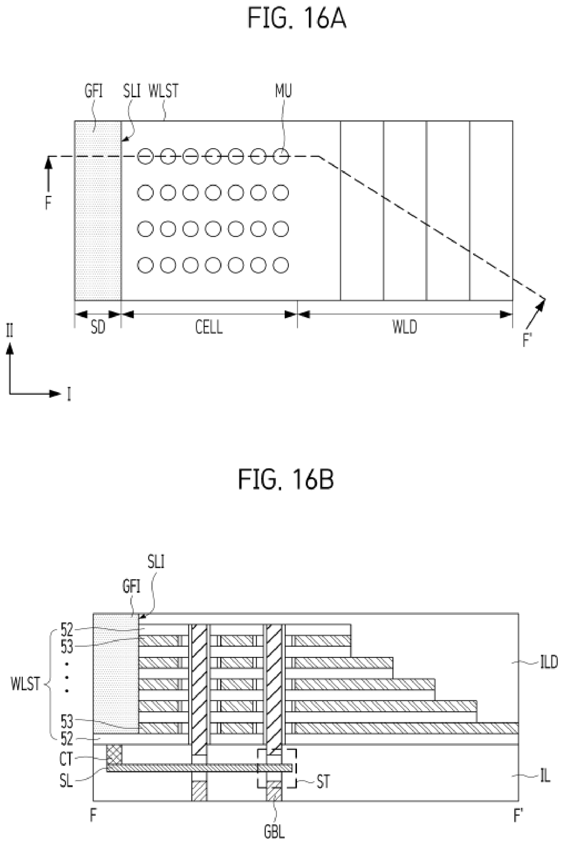

Referring to FIGS. 16A and 16B, a slit SLI penetrating through the stack ST1 is formed. The first material layers 51 may be exposed through the slit SLI. For example, the slit SLI may be formed in the select line decoder region SD of the stack ST1. For reference, although not illustrated in FIGS. 16A and 16B, the slit SLI may also be formed in the cell region CELL and/or the word line decoder region WLD.

Subsequently, the first material layers 51 may be replaced with third material layers 53 through the slit SLI. For example, recess regions may be formed by removing the first material layers 51, and the third material layers 53 may be formed in the recess regions. The third material layers 53 are used to form word lines, and may each include a metal such as tungsten or molybdenum. Through this, a word line stack WLST including the second material layers 52 and the third material layers 53 that are alternately stacked may be formed. Subsequently, a gap-fill insulating layer GFI may be formed in the slit SLI.

For reference, when the first material layers 51 each include a conductive material, a process of replacing the first material layers 51 with the third material layers 53 may be omitted. In such a case, the first material layers 51 may be used as the word lines, and the stack ST1 may be used as the word line stack WLST.

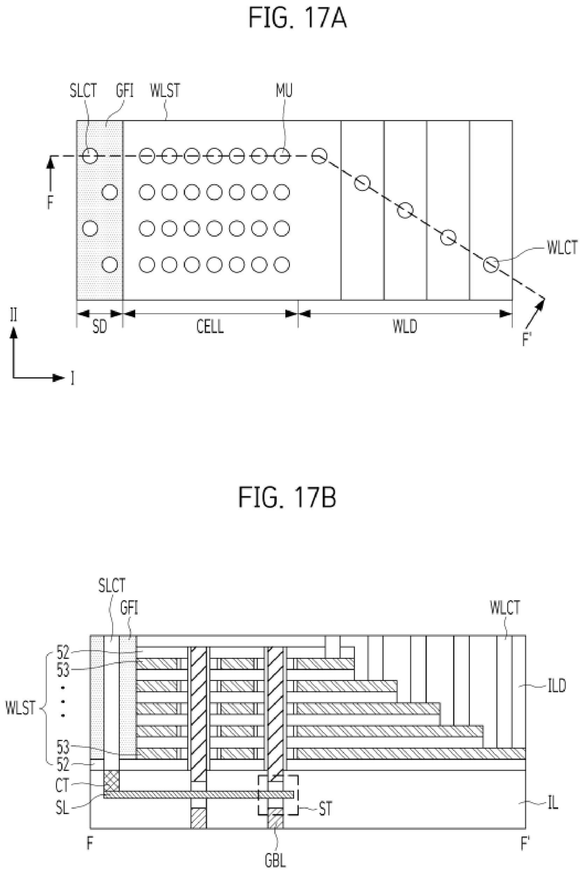

Referring to FIGS. 17A and 17B, word line contact plugs WLCT are formed. The word line contact plugs WLCT may be located in the word line decoder region WLD. The word line contact plugs WLCT may penetrate through the interlayer insulating layer ILD, and may be connected to the third material layers 53, respectively.

While forming the word line contact plugs WLCT, select line contact plugs SLCT may also be formed. The select line contact plugs SLCT may be located in the select line decoder region SD. The select line contact plugs SLCT may penetrate through the gap-fill insulating layer GFI, and may be connected to the contact plugs CT, respectively.

According to the manufacturing method described above, the word line contact plugs WLCT respectively connected to the word lines and the select line contact plugs SLCT respectively connected to the select lines SL may be formed.

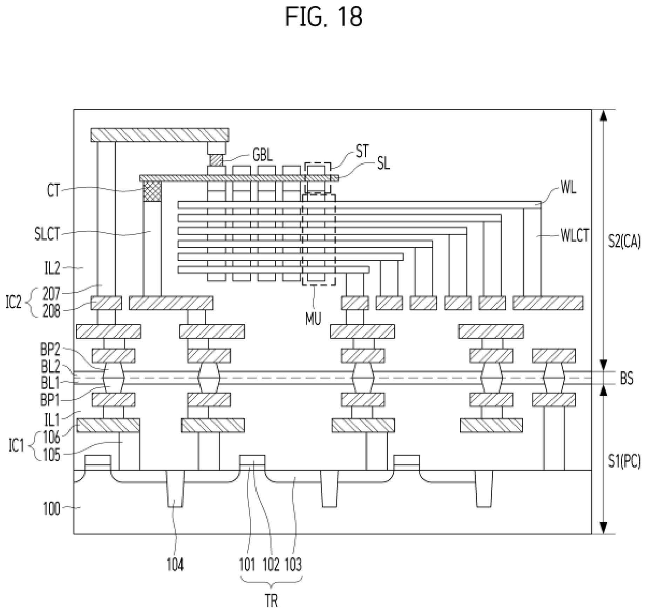

FIG. 18 is a cross-sectional view illustrating a semiconductor device in accordance with an embodiment. Hereinafter, the content overlapping with the previously described content may be omitted.

Referring to FIG. 18, the semiconductor device may include a first semiconductor structure S1, a second semiconductor structure S2, and a bonding structure BS located between the first semiconductor structure S1 and the second semiconductor structure S2. The first semiconductor structure S1 and the second semiconductor structure S2 may be formed by separate processes, and may be electrically connected to each other by the bonding structure BS. For example, the first semiconductor structure S1 may include a peripheral circuit PC, and the second semiconductor structure S2 may include a memory cell array CA.

The first semiconductor structure S1 may include a substrate 100, a transistor TR, a first interconnection structure IC1, and a first interlayer insulating layer IL1. An active region may be defined by an element isolation layer 104 formed in the substrate 100, and the transistor TR may be located in the active region. The transistor TR may include a gate insulating layer 101, a gate electrode 102, and a junction 103. The transistor TR may belong to the peripheral circuit PC.

The first interconnection structure IC1 may be located in the first interlayer insulating layer IL1, and may include a via 105, a wiring line 106, and the like. The first interconnection structure IC1 may be electrically connected to the peripheral circuit PC, and may be electrically connected to the transistor TR.

The second semiconductor structure S2 may include global bit lines GBL, select lines SL, select transistors ST, word lines WL, memory units MU, contact plugs CT, select line contact plugs SLCT, word line contact plugs WLCT, a second interconnection structure IC2, and a second interlayer insulating layer IL2. The word lines WL may be stacked in a staircase shape or stacked in an inverted staircase shape. The select lines SL may be located above or below the word lines WL. The select transistors ST may be located above or below the memory units MU.

The second interconnection structure IC2 may be located in the second interlayer insulating layer IL2 and may include a via 207, a wiring line 208, and the like. The second interconnection structure IC2 may be electrically connected to the global bit lines GBL, the select lines SL, the word lines WL, and the like.

The bonding structure BS may include a first bonding layer BL1, a second bonding layer BL2, a first bonding pad BP1, and a second bonding pad BP2. The first bonding layer BL1 and the second bonding layer BL2 may be in contact with each other, and the first bonding pad BP1 and the second bonding pad BP2 may be in contact with each other. The first bonding layer BL1 and the second bonding layer BL2 may each include SiCN, tetra ethyl ortho silicate (TEOS), or the like. The first bonding pad BP1 may be electrically connected to the first interconnection structure IC1, and the second bonding pad BP2 may be electrically connected to the second interconnection structure IC2. The memory cell array CA and the peripheral circuit PC may be electrically connected to each other through the first bonding pad BP1 and the second bonding pad BP2.

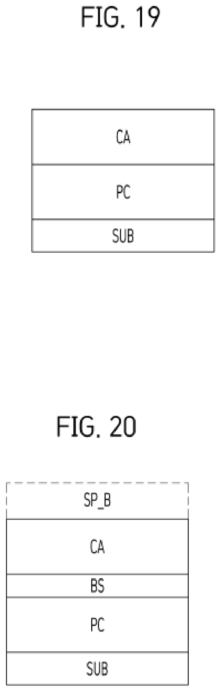

The structure and the manufacturing method according to the above-described embodiments may be applied to semiconductor devices with various configurations. FIGS. 19 and 20 illustrate schematic configurations of semiconductor devices to which the above-described embodiments are applicable.

FIG. 19 is a configuration diagram of a semiconductor device according to an embodiment of the present disclosure.

Referring to FIG. 19, the semiconductor device may include a substrate SUB, a peripheral circuit PC, and a memory cell array CA. Here, the peripheral circuit PC and the memory cell array CA may be formed on the same substrate.

The substrate SUB may be made of or include a semiconductor material. In an embodiment, the semiconductor material may include at least one of a group IV semiconductor, a group III-V compound semiconductor, and a group II-VI compound semiconductor. Here, the group IV semiconductor may include single crystal silicon (Si), polycrystalline silicon, germanium (Ge), or silicon germanium (SiGe). The group III-V compound semiconductor may include GaAs, GaN, GaP, GaAsP, GaInAsP, AlAs, AlGa, InP, InSb, or InGaAs. The group II-VI compound semiconductor may include ZnS, ZnO, or CdS.

The substrate SUB may include a dielectric layer. The substrate SUB may be a silicon-on-insulator (SOI) substrate, a germanium-on-insulator (GeOI) substrate, or a glass substrate. The substrate SUB may include an organic material. In an embodiment, the substrate SUB may include graphene.

The substrate SUB may be a bulk wafer or an epitaxial layer grown using a selective epitaxial growth (SEG) method. Alternatively, the substrate SUB may be formed using a metal induced lateral crystallization (MILC) method and may partially include metal. The substrate SUB may have a single crystalline, polycrystalline, or amorphous state. The substrate SUB may include an impurity of group II, group III, group IV, group V, or group VI. In an embodiment, the substrate SUB may include an n-well region doped with an n-type impurity and/or a p-well region doped with a p-type impurity.

The peripheral circuit PC may be disposed between the substrate SUB and the memory cell array CA. The peripheral circuit PC may include one or more of a row decoder, a column decoder, a page buffer, a logic circuit, a control circuit, a sense amplifier, an input/output circuit, and the like. In an embodiment, the peripheral circuit PC may include an NMOS transistor, a PMOS transistor, a resistor, a capacitor, and the like. The peripheral circuit PC may further include an interconnection structure. The interconnection structure may serve as a path for transferring an operating voltage, and may include components such as a contact plug, a line, and the like.

The memory cell array CA may include memory cells. In an embodiment, the memory cell array CA may include memory strings connected between a source line and a bit line, and each memory string may include stacked memory cells. In an embodiment, the memory cell array CA may include memory cells, each connected between a word line and a bit line. The memory cell array CA may further include an interconnection structure.

FIG. 20 is a configuration diagram of a semiconductor device according to an embodiment of the present disclosure.

Referring to FIG. 20, the semiconductor device may include a substrate SUB, a peripheral circuit PC, a bonding structure BS, and a memory cell array CA. Here, the peripheral circuit PC and the memory cell array CA may be respectively formed on separate substrates and then bonded. The semiconductor device may further include a support base SP_B.

The substrate SUB may serve as a support in a process of forming the peripheral circuit PC. The support base SP_B may serve as a support in a process of forming the memory cell array CA. In an embodiment, a first wafer including the memory cell array CA and a second wafer including the peripheral circuit PC are separately manufactured and then electrically connected via the bonding structure BS. After bonding, at least a portion of the support base SP_B of the first wafer may be removed. The support base SP_B may either be completely removed or partially remain on the memory cell array CA.

The support base SP_B may be a semiconductor substrate, an insulating substrate, a silicon-on-insulator (SOI) substrate, a germanium-on-insulator (GeOI) substrate, or the like. The support base SP_B may be a bulk wafer, an epitaxial layer grown using a selective epitaxial growth (SEG) method, or a layer formed using a metal induced lateral crystallization (MILC) method. The support base SP_B may have a single crystalline, polycrystalline, or amorphous state. The support base SP_B may include an impurity of group II, group III, group IV, group V, or group VI.

The bonding structure BS may connect the memory cell array CA to the peripheral circuit PC. In an embodiment, the memory cell array CA and the peripheral circuit PC may be bonded using a method such as a wafer-on-wafer bonding method, a chip-on-wafer bonding method, a chip-on-chip bonding method, or the like. The bonding structure BS may include one or more of components such as a bonding pad, a bonding layer, a bonding interface, and the like. The bonding pad may include a metal such as copper and aluminum, or their alloys. The bonding interface may be a non-metal-to-non-metal interface, a metal-to-metal interface, or the like. The bonding structure BS facilitates the electrical connection between the memory cell array CA and the peripheral circuit PC.

For reference, the interconnection structures included in the memory cell array CA and/or the peripheral circuit PC may be directly connected without the use of a bonding pad. In an embodiment, a bonding layer from the memory cell array CA and a bonding layer from the peripheral circuit PC may be bonded to form a bonding interface, enabling direct connection of the interconnection structures from the memory cell array CA and the peripheral circuit PC. This allows contact plugs, lines, and similar elements formed on different wafers to be electrically connected without requiring a separate bonding pad.

Other configurations may be identical or similar to those described above with reference to FIG. 19.

Meanwhile, the semiconductor device may feature a structure combining the embodiments described with reference to FIGS. 19 and 20 or a partially modified structure. In the embodiment described with reference to FIGS. 19 and 20, the positions of the memory cell array CA and the peripheral circuit PC may be interchanged. Additionally, one or more memory cell arrays CA and/or peripheral circuits PC may be bonded to the configuration described in FIGS. 19 and 20. In an embodiment, a portion of the peripheral circuitry PC may be integrated in the memory cell array CA.

Although embodiments according to the technical idea of the present disclosure have been described above with reference to the accompanying drawings, this is only for explaining the embodiments according to the concept of the present disclosure, and the present disclosure is not limited to the above embodiments. Various types of substitutions, modifications, changes, and combinations for the embodiments may be made by those skilled in the art, to which the present disclosure pertains, without departing from the technical idea of the present disclosure defined in the following claims, and it should be construed that these substitutions, modifications, changes, and combinations belong to the scope of the present disclosure.

## Claims

1. A semiconductor device, comprising:
channel pillars arranged along a first direction and a second direction intersecting the first direction, wherein the channel pillars are spaced apart by a first interval in the first direction and a second interval in the second direction, the first interval being smaller than the second interval;
a select line surrounding multiple channel pillars arranged in the first direction and extending in the first direction;
word lines stacked above the select line in a third direction perpendicular to the first and the second directions; and
local bit lines extending through the word lines in the third direction and electrically connected to the channel pillars.

2. The semiconductor device of claim 1, further comprising insulating pillars extending through the select lines in the third direction.

3. The semiconductor device of claim 2, further comprising a contact plug electrically connected to the select line, the contact plug being positioned between two adjacent insulating pillars in the first direction.

4. The semiconductor device of claim 1, wherein the plurality of channel pillars arranged in the first direction constitute one row, and the select line surrounds at least one row.

5. The semiconductor device of claim 1, further comprising global bit lines, each connected to channel pillars arranged in the second direction and extending in the second direction.

6. The semiconductor device of claim 5, further comprising select transistors located in regions where the select lines intersect the global bit lines, each select transistor being connected between a global bit line and a corresponding local bit line and including a corresponding one of the channel pillars.

7. The semiconductor device of claim 5, further comprising a global bit line decoder located below the global bit lines in the third direction and connected to the global bit lines.

8. The semiconductor device of claim 1, further comprising a select line decoder located below the select lines in the third direction and connected to the select lines.

9. The semiconductor device of claim 1, further comprising a word line decoder located below the select lines in the third direction and connected to the word lines.

10. The semiconductor device of claim 1, wherein each of the channel pillars includes a first junction, a second junction, and a channel region located between the first junction and the second junction in the third direction.

11. The semiconductor device of claim 10, wherein the select line surrounds the channel region.

12. A semiconductor device, comprising:
local lines arranged in a first direction and a second direction that intersects the first direction, and extending in a third direction perpendicular to the first and the second directions;
global lines extending in the second direction; and
select transistors connected between the local lines and the global lines, each select transistor including a corresponding one of channel pillars, the channel pillars being spaced apart by a first interval in the first direction and a second interval in the second direction, the first interval being different than the second interval.

13. The semiconductor device of claim 12, further comprising select lines connected to gate electrodes of the select transistors and extending in the first direction, wherein the first interval is smaller than the second interval.

14. The semiconductor device of claim 12, wherein the local lines are local bit lines, and the global lines are global bit lines.

15. The semiconductor device of claim 12, further comprising:
word lines surrounding the local lines and stacked in the third direction; and
memory cells connected between the local lines and the word lines.
